# EUROPEAN PATENT APPLICATION

(11) **EP 0 759 564 A1**
(43) Date of publication of application: **26.02.1997**
(21) Application number: 96202229.9
(22) Date of filing: 08.08.1996
(51) Int. Cl.: G02B 5/20, G02F 1/1335, G03C 7/12

(54) **Method of making a color filter array by lamination transfer**

(30) Priority: 22.08.1995 US 2657; 26.04.1996 US 638457
(71) Applicant: EASTMAN KODAK COMPANY, Rochester, New York 14650 (US)
(72) Inventor: DeBoer, Charles David, c/o Eastman Kodak Co., Rochester, New York 14650-2201 (US); Fleissig, Judith Lynn, c/o Eastman Kodak Co., Rochester, New York 14650-2201 (US); Long, Michael Edgar, c/o Eastman Kodak Co., Rochester, New York 14650-2201 (US); Weber, Helmut, c/o Eastman Kodak Co., Rochester, New York 14650-2201 (US)
(74) Representative: Wagner, Karl H., Dipl.-Ing.

(57) **Abstract**

A method for preparing a color filter array element is disclosed which includes providing a temporary support having a flat, clean surface; and photolithographically forming a colored pattern of pixel cells on the temporary support. The method further includes laminating a final support to the surface of the temporary support so that the colored pattern of pixel cells is secured to the final support; and thereafter separating in a clean environment the temporary support from the final support so that a flat, clean surface of the colored pattern of pixel cells is revealed, thereby forming the color filter array element.

## Description

### FIELD OF THE INVENTION

This invention relates to photographically forming a color filter array element with a flat, clean surface.

### BACKGROUND OF THE INVENTION

In U.S. Patent No. 4,965,242 entitled "Method of Making Color Filter Array for Livid Crystal Display," an effective process of making a color filter array element by thermal dye transfer is disclosed. To prepare a color filter array element using such a method, a temporary support having thereon a polymeric alignment layer and a transparent conducting layer is overcoated with an image-receiving layer. The image-receiving layer is overcoated with a colorant donor film including a colorant. A mask is then patterned on the colorant donor film by forming holes in the mask that correspond to the desired color pixel array pattern. The method further includes applying thermal heat to the colorant through the patterned mask to transfer the colorant from the colorant donor film to the image-receiving layer, thus forming a colored pattern of pixel array elements on the image-receiving layer. The colorant donor film is then removed and a final support is laminated to the image-receiving layer containing the colored pattern of pixel cells. Thereafter, the temporary support is removed to reveal the color filter array element.

A useful color filter array element should have good thermal resistance, so that any subsequent high temperature processing of the color filter array element would not degrade the color quality of the pixel cells of the array. The colorants of the pixel cells of the array should also be chosen to have good fade resistance to the viewing light that illuminates them. The colorants must have good color purity, and the overall transmissivity of the color filter array element should be as high as possible, consistent with good color purity and saturation, so that the power of the illuminating lamp need not be excessively high. In addition, the resolution of the color filter array element must be high, so that the images appear sharp and detailed to the eye. The overall uniformity of the image must also be good, meaning that the overall dimensional accuracy of the color filter array element must be high.

Each pixel of a color filter array element must have high micro accuracy, i.e., each pixel must be substantially the same size and shape in order to obtain a uniform density of the overall display. In addition, the placement accuracy of each pixel, i.e., the macro accuracy, must be high. If the pixels are not accurately placed in a uniformly distributed array, the overall visual aspect of the color filter array element can be problematic, for example, can show bands of density or clouds.

Color filter array elements can be used in various display devices such as a liquid crystal display device. In the display of high quality images, it is important that the colored pattern of pixel cells be highly uniform, both in size and in color. A particularly objectionable defect in liquid crystal display devices is a pixel drop-out, i.e., a pixel cell that is always light or always dark. The human eye is drawn to such a cell in an image, in a compulsive and annoying way. The source of such pixel drop-outs is often an electrical short through the livid crystal material in the liquid crystal display device caused by a particle of dust trapped during the steps of coating, patterning, dyeing and washing the color filter array pixels.

Although the color filter array element produced by the thermal dye transfer method, as disclosed in U.S. Patent No. 4,965,242, provides an effective color filter array element, such a method suffers from a number of drawbacks. One problem is that dust particles can get trapped on the surfaces of the color filter array elements during manufacture using the thermal dye transfer method disclosed in U.S. Patent No. 4,965,242, which can cause electrical shorts or pixel drop-outs. In addition, the color filter array elements are susceptible to abrasions and protrusions, which can also cause electrical shorts or pixel drop-outs.

### SUMMARY OF THE INVENTION

Accordingly, it is an object of this invention to provide a method for producing color filter array elements having flat, clean surfaces, without dust specks or protrusions that can cause electrical shorts or pixel drop-outs.

It is another object of this invention is to provide color filter array elements with clean and flat surfaces which are protected from dust and abrasion until the time required for manufacturing steps which act directly on the surfaces of the color filter array elements.

These objects are achieved in a method for preparing a color filter array element, comprising the steps of:
a) photolithographically forming a colored pattern of pixel cells on a temporary support, the temporary support having a flat, clean surface;
b) laminating a final support to the surface of the temporary support so that the colored pattern of pixel cells is secured to the final support; and
c) separating in a clean environment the temporary support from the final support having secured thereon the colored pattern of pixel cells so that a flat, clean surface of the colored pattern of pixel cells is revealed, thereby forming the color filter array element.

### ADVANTAGES

A color filter array element according to this invention provides a color filter array element with a clean, flat surface, without dust specks or protrusions that can cause electrical shorts and pixel drop-outs. A color filter array element according to this invention provides a color filter array element with a clean and flat surface which is protected from dust and abrasion until the time required for manufacturing steps which act directly on the surface of the color filter array element.

A color filter array element according to this invention further provides highly uniform, sharp pixel cells of high color purity, with good dimensional accuracy.

### BRIEF DESCRIPTION OF THE DRAWINGS

FIG. 1 is a schematic sectional view of a color filter array element formed on a flat, clean temporary support in accordance with this invention;
FIG. 2 is a schematic sectional view of a color filter array element laminated to a final support in accordance with this invention; and
FIG. 3 is a schematic sectional view of a liquid crystal display device which includes a color filter array element made in accordance with this invention.

### DETAILED DESCRIPTION OF THE PREFERRED EMBODIMENTS

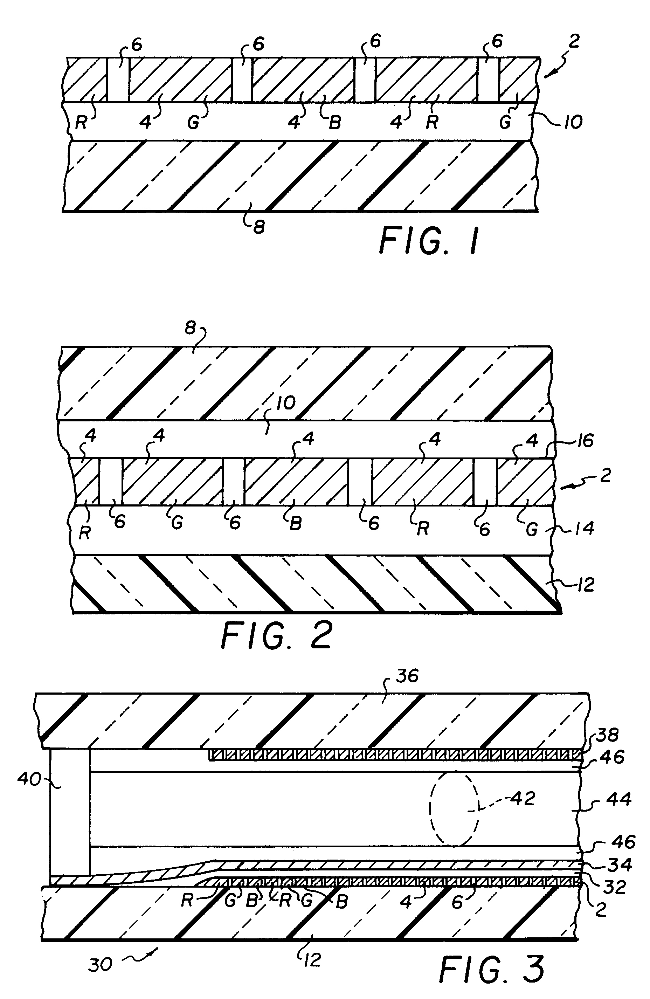

Where parts or elements correspond to FIG. 1, the same numerals will be used. Referring to FIG. 1, a schematic diagram of a color filter array element 2 formed on a temporary support 8 in accordance with this invention is shown. The color filter array element 2 includes red (R), green (G), and blue (B) color cells or pixel cells 4 corresponding to pixels. The pixel cells 4 are separated from each other by an opaque area, e.g., black grid lines 6, to reduce flare and increase viewing contrast.

In accordance with the present invention, the temporary support 8 having a flat, clean surface is overcoated with an optional release layer 10 to facilitate the removal of the temporary support 8 after the lamination step is completed. It is important that the surface of the release layer 10 be clean and flat because it is this surface that defines the surface of the color filter array element 2 after the temporary support 8 is removed. Therefore, the coating solution of the release layer 10 is filtered through a fine filter to remove any dust particles, and is cured in a clean oven.

The color filter array element 2, as shown in FIG. 1, is formed by photolithographically creating a colored pattern of pixel cells 4 on the temporary support 8. To create the colored pattern of pixel cells 4, a colorant is spin coated on the surface of the temporary support 8. The colorant can include pigments or sublimable dyes, which are more fully described below. In the preferred embodiment of the present invention, the colorant includes a dispersion of colored pigment in a solution of polyamic acid resin, such as Darc-102, manufactured by Brewer Scientific, of Ralla, Missouri. The solution of polyamic acid resin is a binder material which facilitates the binding of the colorants to the temporary support 8. It is a problem that if the colorant does not include a binder material, it is first necessary to coat the temporary support 8 with a layer of binder material before spin coating a colorant on the surface of the temporary support 8.

After the dispersion of colored pigment is spin coated on the temporary support 8, the assembly is baked to remove solvents and is then overcoated with a positive working photoresist, i.e. a photoresist that becomes soluble where it has been exposed to light. The photoresist is exposed to an ultra-violet pattern of light corresponding to the desired pixel cells. The photoresist can be exposed either by contact exposure with a film image, or by projection of the image from an optical system. After exposure of the photoresist, the assembly is washed with developer that dissolves away first the photoresist and then the uncovered suspension of pigment in the solution of polyamic acid resin. A developer that can be used in accordance with this invention includes a water solution of tetramethylammonium hydroxide. The color filter array element 2 is then finished by baking assembly to convert the solution of polyamic acid resin to polyimide resin.

The photolithographic process used to create color filter array elements are also described, for example, in U.S. Patent Nos. 4,876,165; 5,176,971; 5,147,844; 5,166,125; and 5,166,126, the disclosures of which are herein incorporated by reference. Various methods other than the photolithographic process disclosed herein can be used to pattern the color filter array element, including inkjet printing, offset printing, and electrostatic printing.

Referring now to FIG. 2, after the color filter array element 2 has been formed on the temporary support 8, the color filter array element 2 is laminated to a final support 12 by heat and pressure, or by an optional glue layer 14. If the glue layer 14 is used, it is important that no air bubbles remain in the glue layer 14 to distort the image. In the preferred embodiment of the present invention, the color filter array element 2 formed on the temporary support 8 is placed in contact with the final support 12, and the glue layer 14 is used such that the fluid epoxy glue which has been centrifuged to remove air bubbles is wicked into the air gap between the temporary support 8 and the color filter array element 2. The force of capillary action causes the fluid glue to fill the entire space between the temporary support 8 and the color filter array element 2, driving out the air as the glue moves across the space. The assembly is then heated to cure the epoxy glue. Then the temporary support 8 is removed in a clean environment at a separation point 16 at the junction between the color filter array element 2 and the release layer 10, revealing the clean, flat surface of the color filter array element 2 of this invention. A clean surface is a surface prepared in a clean environment so that unwanted dust particles, as discussed above, are not deposited on the surface. By the term "clean environment" is meant an environment wherein the air contains a maximum of 100 particles/cubic foot larger than 0.5 micron and 10 particles/cubic foot larger than 5.0 microns. The term "clean environment" is more fully described in Joseph A. Castellano, Handbook of Display Technology, 271-274 (1992), the disclosure of which is herein incorporated by reference.

In an embodiment of the present invention, the color filter array element 2 includes a mosaic pattern having a repeating set of red, green, and blue additive primaries, i.e., red, green, and blue pixel cells 4. The mosaic pattern is preferably used for photographic images. The pixel cells 4 are separated from each other by black grid lines 6. The mosaic pattern of colorant to form the color filter array element 2 includes uniform, linear repeating areas (approximately 100 microns) that can be either scare or rectangular, with one color diagonal displacement as follows:

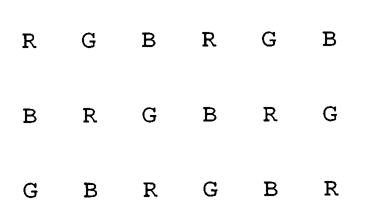

In another embodiment of the present invention, the color filter array element 2 includes a pattern of stripes which include a repeating set red, green, and blue additive primaries, i.e., red, green, and blue pixel cells 4. The pattern of repeating stripes is preferably used for computer monitors. The pixel cells 4 are separated from each other by black grid lines 6. The repeating stripes of colorant to form the color filter array element 2 include uniform, linear repeating areas (approximately 100 microns) that can be either square or rectangular, with no color displacement as follows:

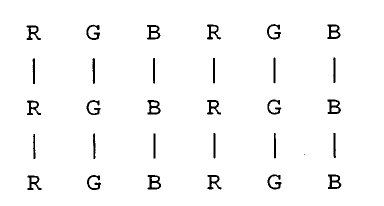

In both the mosaic set and the set of stripes, the size of the set depends on the viewing distance, and is selected so that individual pixels are not visible at the viewing distance. In general, the individual pixels of the set are from about 50 to about 600 microns and do not have to be of the same size.

The temporary support 8 and final support 12 of the present invention can include glass, such as borax glass, boroscilicate glass, chromium glass, crown glass, flint glass, soda glass, and zinc-crown glass. Preferably, boroscilicate glass is employed.

Any material can serve as the release layer 10, provided the surface energy difference between the release layer 10 and the layer in contact with the release layer 10 is large, for example, 30 dynes/cm, and there is no chemical bonding between the two layers. In the preferred embodiment of the present invention where polyimides are employed as the binder material, a suitable release layer 10 is a low surface energy polymer, e.g., a fluorinated polymer such as Teflon® (Dupont Corporation), and also includes a layer of SHC1200® (General Electric Company).

The colorant that is used to form the color filter array element 2 in accordance with the present invention can include any pigment, dye, or mixture of dyes. However, it will be understood that the colorant should be the proper hue and be able to withstand the processing steps of making the color filter array element 2 disclosed herein. Especially good results have been obtained with pigments. Examples of pigments include Litho Red NB-D 3560 (BASF), Heliogen Green K9360 (BASF), Paliogen Blue L 6480 (BASF), and Alkali Blue NBS 6155 D (BASF).

Suitable pigments include the primary colors which are further illustrated by the following structural formulas: 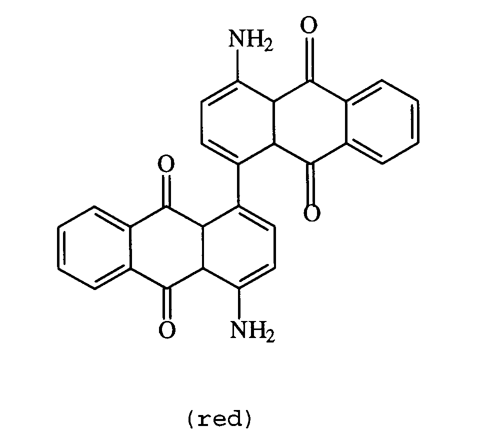 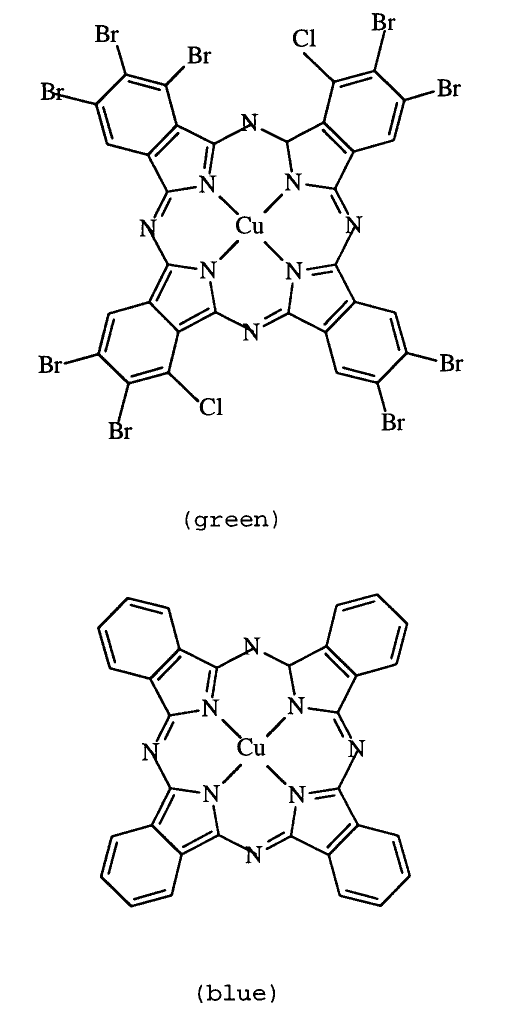 The above pigments are more fully described in Bacchetti et al, Pigmented Photoresist for LCD Color Filters, 165-168, International Display Research Conference (1994), the disclosure of which is herein incorporated by difference.

Dyes that can be used as the colorant include sublimable dyes. Examples of sublimable dyes include anthraquinone dyes, e.g., Sumikalon Violet RS® (Sumito Chemical Co., Ltd.); Dianix Fast Violet 3R-FS® (Mitsubishi Chemical Industries, Ltd.); and Kayalon Polyol Brilliant Blue N-BGM®; Kayalon Polyol Dark Blue 2BM®; and KST Black KR® (Nippon Kayaku Co., Ltd.); Sumickaron Diazo Black 5G® (Mitsui Toatsu Chemicals, Inc.); direct dyes such as Direct Dark Green B® (Mitsubishi Chemical Industries, Ltd.); and Direct Brown M® and Direct Fast Black D® (Nippon Kayaku Co., Ltd.); acid dyes such as Kayanol Milling Cyanine 5R® (Nippon Kayaku Co., Ltd.); basic dyes such as Sumicacryl Blue 6G® (Sumitomo Chemical Co., Ltd.); and Aizen Malachite Green® (Hodogaya Chemical Co., Ltd.); or any of the dyes disclosed in U.S. Patent Nos. 4,541,830; 4,698,651; 4,695,287; 4,701,439; 4,757,046; 4,743,582; 4,769,360; and 4,753,922, the disclosures of which are herein incorporated by reference.

Suitable dyes are further illustrated by the following structural formulas: 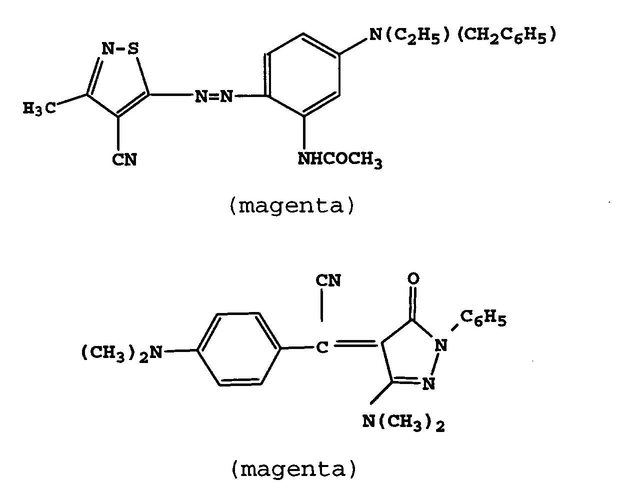 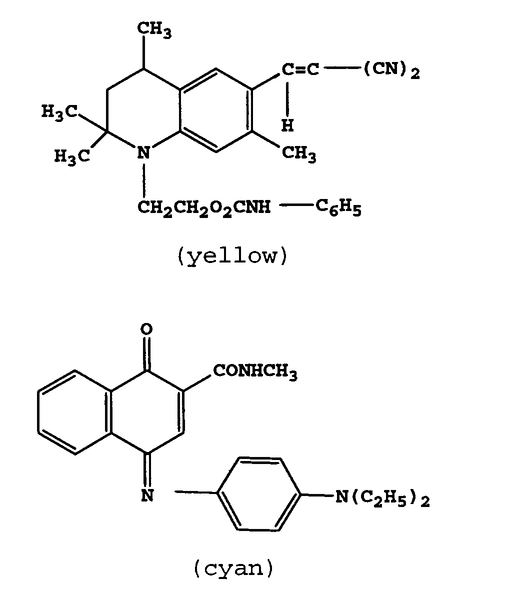 The above subtractive dyes can be employed in various combinations to obtain the desired red, blue, and green additive primary colors, as disclosed in U.S. Patent Nos. 4,957,898; 4,975,410; and 4,988,665, the disclosures of which are herein incorporated by reference.

Color filter array elements of the present invention can be used in various display devices such as a liquid crystal display device. Such liquid crystal display devices are described, for example, in U.K. Patents 2,154,355; 2,130,781; 2,162,674; and 2,161,971.

Referring to FIG. 3, a liquid crystal display device 30 is shown including the color filter array element 2 on the final support 12 in accordance with the present invention. The color filter array element 2 includes red (R), green (G), and blue (B) pixel cells 4 corresponding to pixels. Black grid lines 6 separate each pixel cell 4. The color filter array element 2 is overcoated with a polymeric protective layer 32 and a transparent conducting layer 34. Another support 36 of glass includes electrodes 38 provided thereon which define pixels, either because the electrodes 38 and the transparent conducting layer 34 constitute a cross-bar system in which the crosslinks define the pixels (passive drive), or because the electrodes 38 constitute picture electrodes which are driven by a system (now shown) of switching elements, drive, and data lines (active drive), in which case the electrodes 38 can have a single flat structure. Depending on the image to be displayed, one or more of the pixel electrodes is energized during display operation to allow full light, no light, or partial light to be transmitted through the color filter area associated with that pixel. The image perceived by a user is a blending of colors formed by the transmission of light through adjacent color filter areas. The final support 12 and the glass support 36 are held at a substantially constant distance from each other by a sealing edge 40 and spacers 42.

Referring again to FIG. 3, a layer of liquid crystal material 44, which is liquid crystalline at the operating temperature of the liquid crystal display device 30, is provided between the final support 12 and the glass support 36. The liquid crystal material 44 is overcoated with polymeric alignment layers 46. The polymeric alignment layers 46 are treated to orient the liquid crystal molecules in order to introduce a twist of, e.g., 90 degrees, between the final support 12 and the glass support 36. Thus, the plane of polarization of plane polarized light will be rotated in a 90 degree angle as it passes through the twisted liquid crystal composition from one surface of the liquid crystal display device 30 to the other surface. Application of an electric field between the selected electrodes 38 of the liquid crystal display device 30 causes the twist of the liquid crystal composition to be temporarily removed in the portion of the liquid crystal display device 30 between the selected electrodes 38. By use of optical polarizers on each side of the liquid crystal display device 30, polarized light can pass through the liquid crystal display device 30 or be extinguished, depending on whether or not an electric field is applied. In practice, the liquid crystal display device 30 is further provided with polarizers, reflectors, and other elements in the conventional manner.

The transparent conducting layer 34 is conventional in the liquid crystal art. Materials for the transparent conducting layer 34 of the liquid crystal display device 30 include indium tin oxide, indium oxide, tin oxide, and cadmium stannate. The polymeric alignment layers 46 can be any of the materials commonly used in the liquid crystal art, including polyimides, polyvinyl alcohol, and methyl cellulose.

The polymeric protective layer 32 can be formed by a photopolymerizing layer including a cycloaliphatic epoxide compound such as 3,4-epoxycylohexylmethyl-3,4-epoxycylohexylcarboxylate, and an onium salt of a Lewis acid as a photoinitiator, as described more fully in U.S. Patent No. 5,166,126, the disclosure of which is incorporated herein by reference.

An example of a color filter array element prepared in accordance with this invention is described below.

### Example

A 2 inch square temporary support of soda lime glass having a flat, clean surface was spin coated with GE SCH 1200 (heat curable polymer solution) at 2000 rpm for 2 minutes. The temporary glass support was then baked at 120°C for 30 minutes to cure the SHC layer. The SHC layer was then overcoated by spinning at 2000 rpm with a 5% solution of butyvar B76 (Monsanto) in methy iso-butyl ketone. After spinning for 2 minutes the layer was dry. The assembly was then colored by overcoating with DARC102 (Brewer Scientific) by spinning at 1000 rpm for 2 minutes. The assembly was then baked at 100°C for 1 minute on a hot plate. Then the assembly was baked at 150°C for 30 minutes in an oven. Thereafter, the assembly was overcoated with positive photoresist (OCG 895I) at 2500 rpm for 2 minutes, then baked at 100°C for 1 minute on a hot plate. The assembly was then exposed in contact with a positive film image of the desired pattern (90 x 130 micron pixels on 130 x 160 micron centers) in a vacuum contact frame to 20 units of light (Nu-Arc Model 26-1KS Metal Halide Exposure System). The exposed assembly was then developed in OCG Positive Resist Developer for 30 seconds to remove the color from the exposed areas, rinsed with water and dried by baking at 100°C for 10 minutes. The developed image was then laminated to a final support of borosilicate glass with epoxy glue and allowed to cure overnight. When cured, the temporary support of soda lime glass was removed in a clean environment by lifting the temporary glass support with a razor blade to reveal the flat, clean surface of the colored pattern of pixel cells, thereby forming a color filter array element.

### PARTS LIST

- 2: color filter array element
- 4: pixel cells
- 6: black grid lines
- 8: temporary support
- 10: release layer
- 12: final support
- 14: glue layer
- 16: separation point
- 30: liquid crystal display device
- 32: polymeric protective layer
- 34: transparent conducting layer
- 36: glass support
- 38: electrodes
- 40: sealing edge
- 42: spacers
- 44: liquid crystal material
- 46: alignment layers

## Claims

1. A method for preparing a color filter array element, comprising the steps of:
a) photolithographically forming a colored pattern of pixel cells on a temporary support, the temporary support having a flat, clean surface;
b) laminating a final support to the surface of the temporary support so that the colored pattern of pixel cells is secured to the final support; and
c) separating in a clean environment the temporary support from the final support having secured thereon the colored pattern of pixel cells so that a flat, clean surface of the colored pattern of pixel cells is revealed, thereby forming the color filter array element.

2. The method according to claim 1 wherein the colorant includes a dispersion of colored pigment in a solution of polyamic acid resin.

3. The method according to claim 1 wherein the laminating step uses an epoxy glue.
